Europäisches Patentamt

European Patent Office

Office européen des brevets

(19)

(11) Publication number: **0 120 918 B1**

# (12) EUROPEAN PATENT SPECIFICATION

(45) Date of publication of patent specification: **18.12.91**

(51) Int. Cl.5: **H01L 23/48**, H01L 29/46, H01L 29/62

(21) Application number: **83903284.4**

(22) Date of filing: **26.09.83**

(86) International application number:
**PCT/US83/01505**

(87) International publication number:
**WO 84/01471 (12.04.84 84/10)**

The file contains technical information submitted
after the application was filed and not included in
this specification

(54) **AN ALUMINUM-METAL SILICIDE INTERCONNECT STRUCTURE FOR INTEGRATED CIRCUITS AND METHOD OF MANUFACTURE THEREOF.**

(30) Priority: **30.09.82 US 430188**

(43) Date of publication of application:
**10.10.84 Bulletin 84/41**

(45) Publication of the grant of the patent:
**18.12.91 Bulletin 91/51**

(84) Designated Contracting States:
**AT BE CH DE FR GB LI LU NL SE**

(56) References cited:
EP-A- 0 046 914    GB-A- 2 087 148
US-A- 3 614 547    US-A- 3 881 971
US-A- 4 128 670    US-A- 4 146 413
US-A- 4 180 596    US-A- 4 228 212
US-A- 4 276 557    US-A- 4 348 746

(73) Proprietor: **ADVANCED MICRO DEVICES, INC.**
**901 Thompson Place P.O. Box 3453**
**Sunnyvale, CA 94088(US)**

(72) Inventor: **WOLLESEN, Donald, L.**
**11950 Vallejo Drive**
**Saratoga, CA 95070(US)**
Inventor: **SANDER, Craig, S.**
**20325 Northglen Square**
**Cupertino, CA 94014(US)**
Inventor: **HASKELL, Jacob, D.**
**1301 Forest Avenue**
**Palo Alto, CA 94301(US)**

(74) Representative: **Wright, Hugh Ronald et al**
**Brookes & Martin 52/54 High Holborn**
**London WC1V 6SE(GB)**

IBM TECHNICAL DISCLOSURE BULLETIN, vol. 19, no. 9, February 1977, page 3382, Armonk, N.Y., US; P.L. GARBARINO et al.: "Contact barrier metallurgy for MOSFET gate"

"Nb/GaAs Super-Schottky Diode", IEEE Electron Device Letters, vol. EDL-1, no. 11, pages 236-238, November 1980

Solid State Technology, January 1981, page 70

## Description

### BACKGROUND OF THE INVENTION

### Field of the Invention

This invention relates to an interconnect structure for integrated circuit devices and, more particularly, to a low-resistance aluminum-metal silicide interconnect structure for connecting elements within an integrated circuit and to a method of manufacturing the interconnect structure.

### Description of the Prior Art

Most integrated circuits are formed by active regions at the surface of a semiconductor substrate, typically, on monocrystalline silicon. These active regions are interconnected in part by conducting regions formed at the surface of the substrate. Other interconnecting lines are formed by the deposition of a conducting layer over an insulating layer covering the surface of the substrate. The conducting layer is delineated into interconnecting lines which contact the active regions of the substrate at preselected locations through holes in the insulating layer. Some integrated circuits have another insulating layer covering the interconnecting lines upon which a second set of interconnecting lines is formed. This second interconnecting layer contacts the interconnecting layer below through holes in the second insulating layer or may contact the substrate itself through holes in the first and second insulating layers.

Still more complex integrated circuits have more alternating layers of insulation and conducting material to form more sets of interconnecting lines. Generally, though, most complex integrated circuits have two sets of interconnecting lines, a top layer and an intermediate layer.

These interconnecting lines form the interconnect structure by which the elements, active and passive, of the integrated circuit are electrically coupled for the functioning of the circuit.

In present integrated circuits, the top conducting layer is usually formed from aluminum. The intermediate conducting layer or layers below the top conducting layer are formed from aluminum or polysilicon. Another material which has been examined as a possible candidate for intermediate conducting layers is some refractory metal silicide. All of these materials have various shortcomings.

Refractory metal silicides and polysilicon have the same general shortcomings as intermediate conducting layers. These materials, for example, have high sheet resistances compared with aluminum. Polysilicon sheet resistance is usually equal to or greater than fifteen ohms per square and silicides have sheet reisistances usually equal to or greater than three ohms per square. Such high sheet resistances slow down the speed of integrated circuits. Secondly, these materials typically form high resistance or nonohmic contacts with either or both N+ or P+ regions in the substrate of the semiconductor substrate. In CMOS technology both N+ and P+ regions must contact the conducting lines. Polysilicon and refractory metal silicide interconnecting lines are particularly troublesome because the P or N doping of the interconnecting lines will create a P-N junction with an oppositely doped contact substrate region normally found in a CMOS layout.

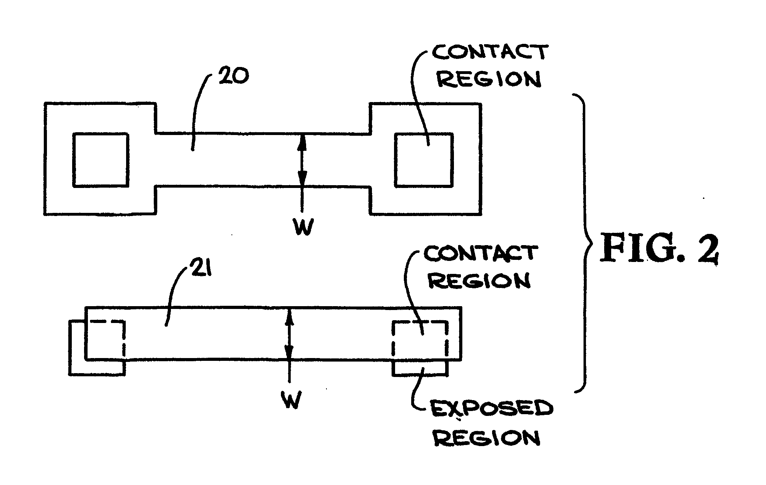

A metal silicide or polysilicon interconnecting line must completely cover the contact region to the substrate, sometimes called "dog boning". The complete overlapping of the contact area by the silicide or polysilicon interconnecting line prevents the silicon substrate surface from gouging because etchants for polysilicon and silicides typically will also etch silicon. Gouging of the substrate silicon is avoided by "dog boning" the interconnecting layer to completely cover the contact region, even with the occurrence of masking misalignments. However, this reduces the density of the integrated circuit. See FIG. 2 which illustrates an interconnection line 20 having "dog bone" contacts and a line 21 which does not. It is easy to see that a set of interconnecting lines having "dog bones" contacts could be less tightly integrated compared to interconnecting lines of the same width W.

Another disadvantageous requirement for refractory metal silicide and polysilicon interconnecting lines is that of high temperature annealing. Any high temperature annealing step, normally at or above $900^\circ$ C, will cause the junction depths of the doped regions of the silicon substrate to diffuse deeper. This increases the parasitic capacitances in the integrated circuit which ultimately reduces its speed.

Another material which has been used in the prior art for an intermediate interconnect layer to avoid the problems above is aluminum. Aluminum has the disadvantage of having bumps on its surface which cause the insulating layer placed over the aluminum to have hillocks. These hillocks, or irregularities, may cause interdielectric short circuits between the intermediate conducting layer and the conducting layer above.

Aluminum also does not provide adequate step coverage in many applications. For example, when aluminum is deposited on the insulating layer covering the substrate, it will not deposit evenly on the sides of a contact opening to the substrate. Rather, the aluminum tends to accumulate in certain places and avoid other places, thereby increasing the likelihood of open circuits in the interconnecting lines formed.

Furthermore, since present day production technology has not yet produced a totally satisfactory plasma etch for aluminum, wet etching is still widely used. Wet etching results in a large masking pitch between neighboring aluminum interconnect lines. This reduces the overall density of the integrated circuit.

Another disadvantage of aluminum is that the material when in contact with silicon, readily absorbs silicon to form an aluminum-silicon compound. This increases the possibility of aluminum spiking into the substrate through shallow P-N junctions used in present day MOS VLSI integrated circuits to cause short circuits.

Still another disadvantage of an intermediate aluminum interconnect layer is that it does not permit the reworking of the top aluminum layer when mistakes in photolithography occur. Since both materials are aluminum, the task of removing the top layer without affecting the intermediate interconnect layer becomes very difficult, if not impossible. An etch of the top layer will invariably remove part of the intermediate layer where contact is made between the two layers.

Finally, since both interconnection layers are aluminium, the top layer is required to have a "dog bone" contact to the lower aluminium layer. Otherwise, the exposed open contact area of the lower aluminium layer will be etched when the top layer is defined into interconnecting lines. As mentioned previously, this increases the masking pitch of the top aluminium layer and reduces the overall density of the integrated circuit.

Attention is also drawn to US Patent Specification 3881971.

Accordingly the present invention provides an integrated circuit having a silicon substrate, a plurality of active regions within a surface of the substrate, a first silicon dioxide layer disposed over that surface of the substrate and having at least one aperture which exposes a selected one of the active regions, and a first conducting layer on the first silicon dioxide layer in a first predetermined pattern so that the first conducting layer contacts at least said selected one of the active regions;

characterised in that the first conducting layer comprises a composite layer including a lower layer of aluminium in combination with an upper conductive layer of a sputtered compound of a refractory metal and silicon.

According to a further aspect, the present invention provides a method of manufacturing an interconnect structure in an integrated circuit comprising

providing a first silicon dioxide layer over a silicon substrate having a plurality of active regions at the surface of said silicon substrate,

forming a composite layer over said first silicon dioxide layer by deposition of a layer of aluminium followed by sputtered deposition of a compound layer of a refractory metal and silicon in such a manner that said compound layer directly contacts said aluminium layer, and

selectively removing parts of said composite layer in a predetermined pattern, whereby an interconnect structure is formed from said composite layer coupling together at least some of said active regions.

## BRIEF DESCRIPTION OF THE DRAWINGS

A more detailed understanding of the present invention may be achieved by the perusal of the following detailed specifications and reference to the following drawings:

Figs 1A to 1E detail the steps of a process used in forming a novel integrated circuit device structure having a triple layer of interconnecting lines of polysilicon, aluminium-refractory metal silicide, and aluminium.

Fig 2 is a top view of an interconnecting line having two "dog bone" contacts and an interconnecting line without such contacts.

## DETAILED DESCRIPTION

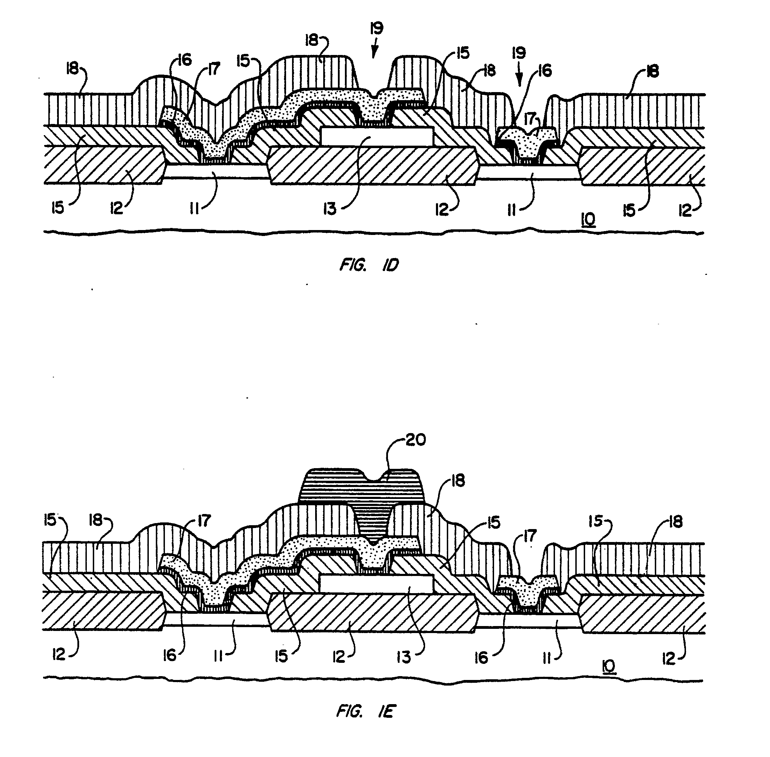

An embodiment for manufacturing the novel interconnect structure is described in FIGS. 1A to 1E.

FIG. 1A illustrates the state of a semiconductor wafer 10 just before an intermediate aluminum-metal silicide interconnection layer is deposited. The substrate 10 has active or diffused regions 11, which are regions heavily doped with N or P type impurities, formed within the surface of substrate 10. Separating these regions 11 are insulating field oxide regions 12. To further isolate the active regions 11, field implant regions, or channel stops, may be placed under the field oxide layers 12. These are not shown in FIG. 1A. An optional conducting layer 13 of polysilicon is deposited upon the field oxide layer 12 to add another set of interconnecting lines to the completed integrated circuit. Over the entire surface of a processed substrate is deposited a layer of silicon dioxide 15. A typical way of deposition is by chemical vapor deposition. Holes 14 are then formed in the oxide layer 15 to expose the active regions 11 and the polysilicon layer 13.

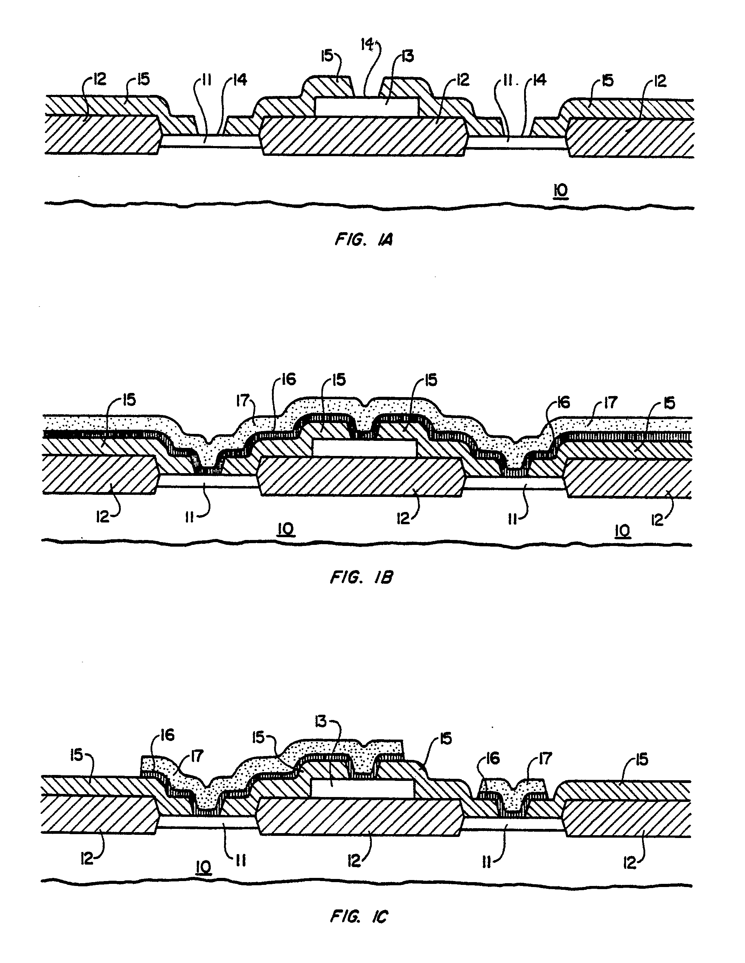

FIG. 1B shows a deposited aluminum-metal silicide composite layer. The composite layer is formed from a thin aluminum layer 16 and an overlying layer of a refractory metal silicide 17. The layer of aluminum 16 is deposited by sputtering; other deposition techniques may be used. Pure aluminum or aluminum with small amounts of silicon or copper have been found to be satisfactory for the layer 16.

The aluminum deposition is followed by the sputter deposition of a refractory metal silicide layer 17. Molybdenum silicide and tantalum silicide have been used successfully as the refractory metal silicide material. Other refractory metal silicides may also be suitable.

To avoid the formation of an oxide layer on the aluminum the refractory metal silicide layer 17 is deposited by sputtering without breaking the system vacuum used in depositing the aluminum layer 16. This ensures good electrical contact between the aluminum 16 and silicide 17. Other deposition methods may also be used but steps must be taken to ensure that an oxide layer is not formed on the aluminum layer 16 when the metal silicide layer 17 is deposited.

The constraints on the thicknesses for the aluminum layer 16 and silicide layer 17 are flexible. In the present exemplary process, a thickness range of 50 to 300 nm (500 to 3000 Angstroms) for the aluminum 16 and a range of 100 to 250 nm (1000 to 2500 Angstroms) for the silicide 17 works quite well. The aluminum-silicide composite layer is then defined and etched to yield the desired interconnect structure as shown in FIG. 1C.

The desired aluminum-silicide pattern is defined using conventional photoresist and exposure techniques. The metal silicide layer 17 is etched in a suitable wet or plasma etch. A plasma of $CCl_2F_2 + SF_6$ has been used successfully. The layer 17 is then used as a mask to define the aluminum layer 16. Since the aluminum layer 16 is thin, it is possible to get a fine resolution pattern for the aluminum. A phosphoric aluminum etch has proved to be a suitable wet etch in the process. Furthermore, it has been found that the wet etch of the aluminum layer 16 can be done either before or after the removal of the photoresist used in defining the silicide layer 17 because the defined silicide layer 17 can be used as a mask for the aluminum layer 16.

The aluminum layer 16 in turn, provides a nearly perfect etch stop for the plasma etch of the metal silicide so that the contact holes 14 (FIG.1A) do not have to be completely covered by the aluminum-silicide pattern to prevent etching of the exposed silicon substrate 10 or polysilicon layer 13. The aluminum etchant for the layer 16 will not attack silicon or polysilicon material. This permits greater integration of the semiconductor device.

After the aluminum-metal silicide layer (FIG. 1B) is deposited and delineated, an interdielectric insulating layer 18 is deposited (FIG. 1D). A silicon dioxide layer from 700 to 800 nm (7,000 to 8,000 Angstroms) thick deposited by low pressure chemical vapor deposition techniques has been used. Other thicknesses may also be used. The layer 18 may be formed in an undoped state and in doped states; the layer 18 with 4% and 8% phosphorous concentrations have been used successfully.

Other materials may also be used for the layer 18 but the material should be conformal and compatible with integrated circuit operation and technology. One constraint of the deposition is that the temperature should be below 450° C so as to avoid excessive aluminum-silicon eutectic formation so that the shallow junctions of the active regions 11 are not shorted out by aluminum spikes into the substrate 10 from the aluminum layer 16.

Using well-known photolithographic techniques the layer 18 is masked and etched so as to open contacts 19 through the layer 18 to the aluminum-metal silicide composite layer. FIG 1D illustrates the contact openings 19 only in areas over the aluminum-silicide pattern. Contacts may also be opened to diffused or active regions 11, the substrate itself and the polysilicon layer 13.

FIG. 1E shows the state of the integrated circuit after a top layer 20 of aluminum has been deposited and defined using standard semiconductor photolithographic technology. It is understood that more alternating layers of aluminum-metal silicide and insulating layers may be placed on the interdielectric layer 18 to provide additional interconnecting layers before the top aluminum layer 20 is deposited.

The integrated circuit structure having an intermediate interconnection layer of aluminum-metal silicide has many advantages over the prior art discussed previously. While the description of the resulting integrated circuit structure is described with reference to FIG. 1E, the structure should not be considered to be as so limited.

Unlike polysilicon layers, the composite layer formed by the aluminum layer 16 and metal silicide layer 17 has low sheet resistances in the range of 0.1 to 0.5 ohms per square, or even less. The composite layer forms the desired low resistance ohmic contacts to the active regions 11 of the substrate 10 through the lower aluminum layer 16. The composite layer can form desirable contacts with N-doped and P-doped silicon, polysilicon, silicide and even other aluminum materials. The present invention is well suited for CMOS technology.

Since the bottom layer 16 is aluminum, "dog bone" contacts are not required. Even if the layer 16 does not completely cover the contact area of the substrate 10, aluminum etchant typically used in defining the layer 16 into an interconnection line will not gouge the substrate 10. Thus the present structure permits greater integration.

No high temperature annealing is required for the composite layer. This is useful in maintaining the speed of the integrated circuit by keeping the junction depths of the active regions shallow and avoiding increased parasitic capacitance.

The composite layer has advantages over an aluminum intermediate interconnection layer. The top layer 17 is metal silicide, to permit a smooth coverage by the insulating layer 18. This decreases the likelihood of open circuits in the top conducting layers over the insulating layer 18.

Step coverage problems are also reduced with the present invention. Any inconsistencies of coverage by the aluminum layer 16 is compensated by the metal silicide layer 17.

Furthermore, the layer 17 is a source of silicon for the aluminum layer 16 below. This reduces the possibility of aluminum spiking through shallow P-N junctions in the substrate. The thinness of the aluminum layer 16 also reduces the amount of silicon absorbed from the substrate contact areas.

With the composite layer the top aluminum layer 20 can be reworked, since the metal silicide layer 17 is exposed to the etchants for removing the layer 20. The layer 17 is an effective barrier against the aluminum etchants reaching the underlying layer 16. Furthermore, since the layer 17 acts as a barrier against the etchants for the top layer 20, the top layer contact areas are not required to be a "dog bone", which permits the top aluminum layer to be defined more densely by photolithographic techniques.

Finally, since the interconnect structure has the silicide layer 17 electrically in parallel with the aluminum layer 16, it is believed that the likelihood of current density induced aluminum electromigration, which may cause open circuits to form, is reduced.

Although the invention has been described relative to a specific embodiment, it is not so limited and, in the light of the above teaching, numerous variations and modifications thereof will be readily apparent to those skilled in the art. It is therefore to be understood that within the scope of the appended claims the invention may be practiced otherwise than as specifically described.

## Claims

1. An integrated circuit having a silicon substrate (10), a plurality of active regions (11) within a surface of the substrate, a first silicon dioxide layer (15) disposed over that surface of the substrate and having at least one aperture (14) which exposes a selected one of the active regions, and a first conducting layer (16, 17) on the first silicon dioxide layer in a first predetermined pattern so that the first conducting layer contacts at least said selected one of the active regions;

   characterised in that the first conducting layer comprises a composite layer including a lower layer (16) of aluminium in combination with an upper conductive layer (17) of a sputtered compound of a refractory metal and silicon.

2. The circuit as claimed in claim 1, characterised by:

   a second silicon dioxide layer (18) over said first silicon dioxide layer and said first conducting layer, said second silicon dioxide layer having at least one opening (19) exposing a preselected portion of said first conducting layer, and

   a second conducting layer (20) of aluminium on said second silicon dioxide layer in a second predetermined pattern so that said second conducting layer contacts said first conducting layer

   whereby a multilayer interconnected conducting structure is formed.

3. The circuit as claimed in claims 1 or 2 characterised by

   a polysilicon layer (13) in a third predetermined pattern between said first silicon dioxide layer (15) and said substrate (10), and

   a third silicon dioxide layer (12) between said polysilicon layer (13) and said substrate (10) whereby a third conducting layer is added to said multilayer conducting structure.

4. The circuit as claimed in any of claims 1 to 3 characterised in that said refractory metal comprises a metal from the group consisting of molybdenum and tantalum.

5. The circuit as claimed in any of claims 1 to 4 characterised in that said aluminium layer in said composite layer has a thickness in the range of 50 to 300 Nanometres.

6. The circuit as claimed in any of claims 1 to 5 characterised in that said compound layer in said composite layer has a thickness in the range of 100 to 250 Nanometres.

7. A method of manufacturing an interconnect structure in an integrated circuit comprising

   providing a first silicon dioxide layer (15) over a silicon substrate (10) having a plurality of active regions (11) at the surface of said silicon substrate (10),

   forming a composite layer (16, 17) over said first silicon dioxide layer by deposition of a layer (16) of aluminium followed by sputtered deposition of a compound layer (17) of a refractory metal and silicon in such a manner that said compound layer directly contacts said aluminium layer, and

selectively removing parts of said composite layer in a predetermined pattern, whereby an interconnect structure is formed from said composite layer coupling together at least some of said active regions.

8. The method as claimed in claim 7 characterised in that said composite layer removing step comprises

selectively etching said compound layer into said predetermined pattern,

selectively etching said aluminium layer into said predetermined pattern by using said etched compound layer (17) as a mask.

9. The method as claimed in any of claims 7 or 8, characterised in that said refractory metal comprises a metal selected from the group consisting of molybdenum and tantalum.

10. The method as claimed in any of claims 7 to 9 characterised in that said aluminium layer is formed to a thickness in the range of 50 to 300 Nanometres.

11. The method as claimed in any of claims 7 to 10 characterised in that said compound layer is formed to a thickness in the range of 100 to 250 Nanometres.

12. The method as claimed in any of claims 7 to 11 characterised by,

depositing a second layer of silicon dioxide (18) over said selectively etched composite layer said second silicon dioxide layer (18) having at least one aperture (19) exposing said compound layer of the composite layer at a predetermined location,

depositing a second layer (20) of aluminium over said second silicon dioxide layer (18),

selectively etching said second aluminium layer into a second predetermined pattern so that said second aluminium layer contacts said compound layer through said second silicon dioxide layer,

whereby an integrated circuit having an intermediate conducting layer of aluminium and such compound is formed.

13. The method as claimed in any of claims 7 to 12 characterised in that said aluminium depositing step is performed by sputtering in a vacuum, and said compound deposition step is performed by sputtering a refractory metal silicon compound after said aluminium sputtering step without breaking said vacuum so as to prevent the formation of an insulating oxide layer on said aluminium before the sputtering of said compound.

14. The method as claimed in any of claims 9 to 13 characterised in that said compound layer etching step comprises

placing a photoresist layer over said compound layer,

defining said photoresist layer into said predetermined pattern,

etching said compound layer using said photoresist layer as a mask;

and characterised by said aluminium layer etching step comprises etching said aluminium layer using said photoresist layer or said etched compound layer as a mask.

**Revendications**

1. Circuit intégré comportant un substrat de silicium (10), plusieurs régions actives (11) dans une surface du substrat, une première couche de dioxyde de silicium (15) disposée au-dessus de cette surface du substrat et comprenant au moins une ouverture (14) qui expose l'une sélectionnée des régions actives et une première couche conductrice (16, 17) sur la première couche de dioxyde de silicium dans une première configuration prédéterminée de manière que la première couche conductrice soit en contact avec au moins ladite sélectionnée des régions actives ;

caractérisé en ce que la première couche conductrice consiste en une couche composite comprenant une couche inférieure (16) d'aluminium en combinaison avec une couche conductrice supérieure (17) d'un composé pulvérisé d'un métal réfractaire et de silicium.

2. Circuit selon la revendication 1, caractérisé en ce qu'il comporte également :

une seconde couche de dioxyde de silicium (18) au-dessus de ladite première couche de dioxyde de silicium et de ladite première couche conductrice, ladite seconde couche de dioxyde de silicium comprenant au moins une ouverture (19) exposant une partie prédéterminée de ladite première couche conductrice, et

une seconde couche conductrice (20) d'aluminium sur ladite seconde couche de dioxyde de silicium dans une seconde configuration prédéterminée de manière que ladite seconde couche conductrice soit en contact avec ladite première couche conductrice,

de manière à former une structure conductrice interconnectée à couches multiples.

3. Circuit selon la revendication 1 ou 2, caractérisé en ce qu'il comporte également :

une couche de polysilicium (13) dans une troisième configuration prédéterminée entre ladite première couche de dioxyde de silicium (15) et ledit substrat (10), et

une troisième couche de dioxyde de silicium (12) entre ladite couche de polysilicium (13) et ledit substrat (10) de manière qu'une troisième couche conductrice soit ajoutée à ladite structure conductrice à couches multiples.

4. Circuit selon l'une quelconque des revendications 1 à 3, caractérisé en ce que ledit métal réfractaire consiste en un métal du groupe comprenant le molybdène et le tantale.

5. Circuit selon l'une quelconque des revendications 1 à 4, caractérisé en ce que ladite couche d'aluminium dans ladite couche composite a une épaisseur dans la plage de 50 à 300 nanomètres.

6. Circuit selon l'une quelconque des revendications 1 à 5, caractérisé en ce que ladite couche composée dans ladite couche composite a une épaisseur dans la plage de 100 à 250 nanomètres.

7. Procédé de fabrication d'une structure d'interconnexion dans un circuit intégré, consistant :

à produire une première couche de dioxyde de silicium (15) sur un substrat de silicium (10) comprenant plusieurs régions actives (11) à la surface dudit substrat de silicium (10),

à former une couche composite (16, 17) sur ladite première couche de dioxyde de silicium par dépôt d'une couche (16) d'aluminium suivie par le dépôt pulvérisé d'une couche composée (17) d'un métal réfractaire et de silicium d'une manière que ladite seconde couche composée soit en contact direct avec ladite couche d'aluminium, et

à éliminer sélectivement des parties de ladite couche composite dans une configuration prédéterminée de manière à former une structure d'interconnexion à partir de ladite couche composite couplant ensemble au moins certaines desdites régions actives.

8. Procédé selon la revendication 7, caractérisé en ce que ladite opération d'élimination de la couche composite consiste :

à graver sélectivement ladite couche composée dans ladite configuration prédéterminée,

à graver sélectivement ladite couche d'aluminium dans ladite configuration prédéterminée en utilisant ladite couche composée gravée (17) en tant que masque.

9. Procédé selon la revendication 7 ou 8, caractérisé en ce que ledit métal réfractaire consiste en un métal choisi dans le groupe comprenant le molybdène et le tantale.

10. Procédé selon l'une quelconque des revendications 7 à 9, caractérisé en ce que l'épaisseur de ladite couche d'aluminium est dans la plage de 50 à 300 nanomètres.

11. Procédé selon l'une quelconque des revendications 7 à 10, caractérisé en ce que l'épaisseur de ladite couche composée est dans la plage de 100 à 250 nanomètres.

12. Procédé selon l'une quelconque des revendications 7 à 11, caractérisé en ce qu'il consiste également :

à déposer une seconde couche de dioxyde de silicium (18) sur ladite couche composite gravée sélectivement, ladite seconde couche de dioxyde de silicium (18) ayant au moins une ouverture (19) exposant ladite couche composée de la couche composite dans une position prédéterminée,

à déposer une seconde couche (20) d'aluminium sur ladite seconde couche de dioxyde de silicium (18), à graver sélectivement ladite seconde couche d'aluminium dans une seconde configuration prédéterminée de manière que ladite seconde couche d'aluminium soit en contact avec ladite couche composée à travers ladite seconde couche de dioxyde de silicium,

de manière à former un circuit intégré comprenant une couche conductrice intermédiaire d'aluminium et de ce composé.

13. Procédé selon l'une quelconque des revendications 7 à 12, caractérisé en ce que ladite opération de dépôt d'aluminium est effectuée par pulvérisation sous vide et ladite opération de dépôt de composé est effectuée par pulvérisation d'un composé de silicium métallique réfractaire après ladite opération de pulvérisation d'aluminium sans rompre ledit vide de manière à éviter la formation d'une couche d'oxyde isolante sur ledit aluminium avant la pulvérisation dudit composé.

14. Procédé selon l'une quelconque des revendications 9 à 13, caractérisé en ce que ladite opération de gravure de la couche composée consiste :

à placer une couche photosensible sur ladite couche composée,

à définir ladite couche photosensible dans ladite configuration prédéterminée,

à graver ladite couche composée en utilisant ladite couche photosensible comme un masque ,

et caractérisé en ce que ladite opération de gravure de la couche d'aluminium consiste à graver ladite couche d'aluminium en utilisant ladite couche photosensible ou ladite couche composée gravée en tant que masque.

**Patentansprüche**

1. Integrierte Schaltung mit einem Siliziumsubstrat (10), mehreren aktiven Bereichen (11) innerhalb der Oberfläche des Substrats, einer ersten Siliziumdioxidschicht (15), die über dieser Oberfläche des Substrats angeordnet ist und wenigstens eine Öffnung (14) aufweist, die einen ausgewählten der aktiven Bereiche freilegt, und einer ersten leitenden Schicht (16, 17) auf der ersten Siliziumdioxidschicht in einem ersten vorbestimmten Muster, derart, daß die erste leitende Schicht wenigstens den ausgewählten der aktiven Bereiche berührt;

dadurch gekennzeichnet, daß die erste leitende Schicht eine Verbundschicht aufweist, die eine untere Schicht (16) aus Aluminium in Kombination mit einer oberen leitenden Schicht (17) aus einer aufgesputterten Zusammensetzung aus schwerschmelzendem Metall und Silizium aufweist.

2. Schaltung nach Anspruch 1, gekennzeichnet durch:

- eine über der ersten Silziumdioxidschicht und der ersten leitenden Schicht vorgesehene zweite Siliziumdioxidschicht (18), die wenigstens eine Öffnung (19) aufweist, welche einen vorgewählten Bereich der ersten leitenden Schicht freilegt, und

- eine über der zweiten Siliziumdioxidschicht derart in einem zweiten vorbestimmten Muster vorgesehene zweite leitende Schicht (20), daß die zweite leitende Schicht die erste leitende Schicht berührt,

- wodurch eine mehrlagige, verbundene leitende Struktur geschaffen ist.

3. Schaltung nach Anspruch 1 oder 2, gekennzeichnet durch

- eine Polysiliziumschicht (13) in einem dritten vorbestimmten Muster zwischen der ersten Siliziumdioxidschicht (15) und dem Substrat (10), und

- eine dritte Siliziumdioxidschicht (12) zwischen der Polysiliziumschicht (13) und dem Substrat (10), wodurch der mehrlagigen leitenden Struktur eine dritte leitende Schicht hinzugefügt ist.

4. Schaltung nach einem der Ansprüche 1 bis 3, dadurch gekennzeichnet, daß das schwerschmelzende Metall ein Metall aus der Gruppe aufweist, die aus Molybden und Tantal besteht.

5. Schaltung nach einem der Ansprüche 1 bis 4, dadurch gekennzeichnet, daß die Aluminiumschicht in der Verbundschicht eine Dicke in dem Bereich von 50 bis 300 Nanometern hat.

6. Schaltung nach einem der Ansprüche 1 bis 5, dadurch gekennzeichnet, daß die Zusammensetzungsschicht in der Verbundschicht eine Dicke in dem Bereich von 100 bis 250 Nanometern hat.

7. Verfahren zum Herstellen einer verbundenen Struktur in einer integrierten Schaltung, mit den folgenden Schritten:

- Vorsehen einer ersten Siliziumdioxidschicht (15) über einem Siliziumsubstrat (10) mit mehreren aktiven Bereichen (11) an der Oberfläche des Siliziumsubstrats (10),

- Bilden einer Verbundschicht (16, 17) über der ersten Siliziumdioxidschicht durch Aufbringen einer Schicht (16) aus Aluminium, gefolgt von einer Sputterungsablagerung einer Zusammensetzungsschicht (17) aus einem schwerschmelzenden Metall und Silizium, derart, daß die Zusammensetzungsschicht die Aluminiumschicht direkt berührt, und

- selektives Entfernen von Teilen der Verbundschicht nach einem vorbestimmten Muster, wodurch aus der Verbundschicht eine verbundene Struktur gebildet wird, die wenigstens einige der aktiven Bereiche verbindet.

8. Verfahren nach Anspruch 7, dadurch gekennzeichnet, daß der Schritt des Entfernens der Verbundschicht beinhaltet:

- das selektive Ätzen der Zusammensetzungsschicht in dem vorbestimmten Muster,

- das selektive Ätzen der Aluminiumschicht in dem vorbestimmten Muster durch Verwendung der geätzten Zusammensetzungsschicht (17) als Maske.

9. Verfahren nach einem der Ansprüche 7 oder 8, dadurch gekennzeichnet, daß das schwerschmelzende Metall ein Metall aus der Gruppe aufweist, die aus Molybden und Tantal besteht.

10. Verfahren nach einem der Ansprüche 7 bis 9, dadurch gekennzeichnet, daß die Aluminiumschicht mit einer Dicke in dem Bereich von 50 bis 300 Nanometern ausgebildet wird.

11. Verfahren nach einem der Ansprüche 7 bis 10, dadurch gekennzeichnet, daß die Zusammensetzungsschicht mit einer Dicke in dem Bereich von 100 bis 250 Nanometern ausgebildet wird.

12. Verfahren nach einem der Ansprüche 7 bis 11, gekennzeichnet durch:
    - das Aufbringen einer zweiten Siliziumdioxidschicht (18) über der selektiv geätzten Verbundschicht, wobei die zweite Siliziumdioxidschicht (18) wenigstens eine Öffnung (19) aufweist, welche die Zusammensetzungsschicht der Verbundschicht an einer vorbestimmten Stelle freilegt,
    - das Aufbringen einer zweiten Aluminiumschicht (20) über der zweiten Siliziumdioxidschicht (18),
    - das selektive Ätzen der zweiten Aluminiumschicht in einem vorbestimmten Muster, derart, daß die zweite Aluminiumschicht die Zusammensetzungsschicht durch die zweite Siliziumdioxidschicht hindurch berührt,
    - wodurch eine integrierte Schaltung mit einer leitenden Zwischenschicht aus Aluminium und einer derartigen Zusammensetzung gebildet wird.

13. Verfahren nach einem der Ansprüche 7 bis 12, dadurch gekennzeichnet, daß der Schritt des Aufbringens des Aluminiums durch Aufsputtern in Vakuum erfolgt, und der Schritt des Aufbringens der Zusammensetzung durch Aufsputtern einer Zusammensetzung aus schwerschmelzendem Metall und Silizium ohne Unterbrechung des Vakuums erfolgt, um zu verhindern, daß sich vor dem Aufsputtern der Zusammensetzung eine isolierende Oxidschicht auf dem Aluminium bildet.

14. Verfahren nach einem der Ansprüche 9 bis 13, dadurch gekennzeichnet, daß der Schritt des Ätzens der Zusammensetzungsschicht beinhaltet:
    - das Anordnen einer fotoresistenten Schicht über der Zusammensetzungsschicht,
    - das Ausbilden der fotoresistenten Schicht in dem vorbestimmten Muster,
    - das Ätzen der Zusammensetzungsschicht unter Verwendung der fotoresistenten Schicht als Maske,
    und dadurch gekennzeichnet, daß der Schritt des Ätzens der Aluminiumschicht das Ätzen der Aluminiumschicht unter Verwendung der fotoresistenten Schicht oder der geätzten Zusammensetzungsschicht als Maske beinhaltet.

FIG. IA

FIG. IB

FIG. IC

FIG. ID

FIG. IE

FIG. 2